# FASCICULE DE BREVET EUROPEEN

(11) **EP 0 852 429 B1**
(45) Date de publication et mention de la délivrance du brevet: **10.04.2002**
(21) Numéro de dépôt: 98400009.1
(22) Date de dépôt: 06.01.1998
(51) Int. Cl.: H03K 17/96

(54) **Clavier étanche et appareil comportant un tel clavier**
Abgedichtete Tastatur und Vorrichtung damit
Sealed keyboard and apparatus comprising the same

(30) Priorité: 07.01.1997 FR 9700072
(43) Date de publication de la demande: 08.07.1998
(73) Titulaire: Jaeger Regulation Société Anonyme, 28000 Chartres (FR)
(72) Inventeur: Lomp, Stéphane, 28000 Chartres (FR)
(74) Mandataire: Cabinet HERRBURGER

(56) Documents cités:
- EP-A- 0 688 102
- FR-A- 2 555 841
- D. M. TAUB: "Electric Circuit" IBM TECHNICAL DISCLOSURE BULLETIN., vol. 10, no. 7, décembre 1967, NEW YORK US, page 1069 XP002040515

## Description

La présente invention se rapporte principalement à un clavier étanche et à un appareil, notamment un appareil de cuisson comportant un tel clavier.

Les appareils domestiques ou industriels sont fréquemment commandés par des claviers.

On utilise habituellement un clavier étanche pour éviter les agressions en environnement sévère ou pour protéger le milieu contre des risques d'explosion ou de pollution du milieu provoqués par le fonctionnement du clavier.

FR-A-2 699 349 décrit un clavier étanche, notamment pour table vitrocéramique. Bien que donnant généralement satisfaction, ce clavier présente certains inconvénients. La présence d'un doigt sur une touche sensitive de ce clavier provoque une baisse de la tension de sortie. De plus, les perturbations électromagnétiques risquent d'induire une fausse alerte, c'est-à-dire la détection, en l'absence de doigt sur une touche du clavier, d'un signal correspondant normalement à la présence du doigt sur la touche. De plus, ce clavier est d'une construction relativement complexe.

Il est également connu selon le document D.M. TAUB « Electric Circuit » IBM Technical Disclosure Bulletin décrit un circuit dont les bornes + et - sont court-circuitées par un tube (2) déclenché par un condensateur (4) lorsqu'on pose un doigt au point (3) du circuit.

Ce circuit ne présente pas la sécurité requise car il y a simplement une modification de la fréquence par l'introduction du condensateur lors de la pose du doigt sur la touche.

Le document EP-A-0 688 102 décrit un dispositif également par touches à commande tactile. L'application d'un doigt sur une touche du clavier réduit l'amplitude du signal au niveau du récepteur.

Là encore, le circuit manque de sécurité et présente les inconvénients déjà soulignés ci-dessus.

La présente invention a pour but de développer un clavier étanche par rapport à son environnement, susceptible de fonctionner avec une fiabilité élevée en environnement sévère et, notamment, de minimiser les fausses alertes, présentant un faible coût de revient, facile à mettre en oeuvre dans un dispositif, notamment dans une table de cuisson de type à plaque supérieure vitrocéramique ainsi qu'un appareil de cuisson comportant un tel clavier permettant le réglage de la puissance moyenne des éléments chauffants.

Le problème de l'invention est résolu par les moyens énoncés dans la revendication indépendante.

L'invention a aussi pour objet un clavier, caractérisé en ce que le générateur unidirectionnel haute fréquence comporte, connectés en série, un oscillateur, notamment à comparateur, et des moyens redresseurs, notamment une diode.

Le clavier est caractérisé en ce qu'il comporte un circuit imprimé et en ce que la borne ou antenne formant une touche du clavier comporte un élément élastique saillant à partir du circuit imprimé.

Le clavier est caractérisé en ce qu'il comporte une paroi étanche et rigide dont une première face reçoit la borne ou l'antenne formant touche et dont la seconde face comporte, disposé en vis-à-vis de la borne ou antenne formant une touche, un emplacement de réception d'un doigt.

Le clavier est également caractérisé en ce que la paroi étanche et rigide est réalisée en vitrocéramique.

Le clavier est un clavier de commande de puissance d'un appareil électrique et/ou électronique.

L'invention a également pour objet un appareil électrique et/ou électronique, caractérisé en ce qu'il comporte au moins un tel clavier.

Cet appareil est caractérisé en ce qu'il est un appareil ménager, notamment un appareil de cuisson, notamment une table de cuisson comportant au moins un foyer chauffant pour ustensiles de cuisine et en ce que le clavier commande la puissance moyenne délivrée par le ou les foyers.

L'invention sera mieux comprise au moyen de la description ci-après et de la figure annexée donnée comme un exemple non limitatif comportant un schéma de l'exemple préféré de réalisation d'un clavier comportant une touche selon la présente invention.

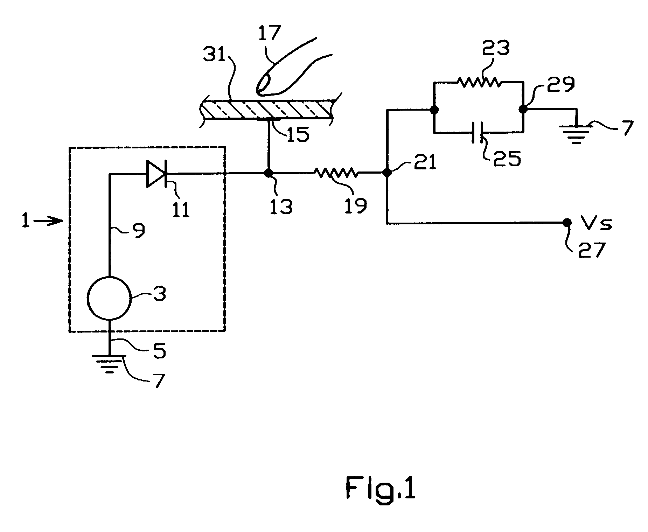

Sur le dispositif de la figure 1 on a illustré une touche unique, étant bien entendu qu'un clavier comportant une pluralité de touches de commandes et/ou alphanumériques ne sort pas du cadre de la présente invention.

Le dispositif de la figure 1 comporte un générateur 1 de courant unidirectionnel haute fréquence comprise, par exemple, entre 100 kHz et 2 MHz, de préférence entre 700 kHz et 1 MHz, par exemple égale à 800 kHz.

Le générateur 1 comporte par exemple un oscillateur 3, de préférence de type à comparateur, dont une première entrée 5 est reliée à la masse 7 et dont la sortie 9 est reliée à l'entrée de moyens redresseurs 11, par exemple d'une diode. La sortie 13 de la diode 11 est reliée, d'une part à un capteur 15 de présence d'un doigt 17, notamment d'une antenne, et, d'autre part, à l'entrée d'une résistance 19.

La sortie 21 de la résistance 19 est reliée, d'une part aux entrées d'une résistance 23 et d'un condensateur 25 et, d'autre part, à une borne 27 de sortie du dispositif. Les sorties 29 de la résistance 23 et du condensateur 25 sont reliées à la terre 7.

Dans l'exemple préféré de réalisation, on a utilisé les composants suivants :
- oscillateur 3 : oscillateur à comparateur fournissant une tension alternative variant entre 0 et 30 V à 800 kHz avec un rapport cyclique de 30 % de tension continue. L'oscillateur 3 fournit des signaux sinusoïdaux, des signaux carrés ou autres ;
- diode 11 : 1N4148 ;
- antenne 15 : métallisation disposée sur un circuit imprimé en forme d'un bâtonnet, d'un disque, d'un cercle, d'une spirale circulaire, d'une spirale carrée, rectangulaire,. ovale ou autre ou, sous forme d'un élément saillant par rapport à un circuit imprimé portant les autres composants du clavier, notamment de type ressort décrit dans la Demande de Brevet Français n° 2 739 233.
- la résistance 19 a une valeur de 200 kΩ ;
- la résistance 23 a une valeur de 100 kΩ ; et
- le condensateur 25 a une valeur de 10 nF.

Dans l'exemple préféré de réalisation, l'oscillateur 3 délivre des signaux carrés d'amplitude de 30 V par rapport à la masse avec un rapport cyclique de 30 % à une fréquence de 800 kHz. L'antenne 15 est recouverte par une plaque 31 en vitrocéramique ayant une épaisseur par exemple égale à 4 mm. En régime permanent, temps de réponse supérieur à 10 ms, la tension Vs entre la borne 27 et la masse 7 est une tension continue. Sans le doigt 17 posé sur la touche, la tension Vs est égale à 2,6 V, alors qu'une fois le doigt 17 posé sur la touche, la tension monte à 2,9 V.

Lorsque l'utilisateur pose le doigt 17 sur la touche du clavier selon la présente invention, il se forme un condensateur dont la première armature est constituée par l'antenne 15 et la seconde armature par le doigt 17. La charge de ce condensateur assure une augmentation de la tension Vs entre la borne 27 et la masse 7.

La présente invention s'applique à tout dispositif comportant un clavier étanche et/ou un clavier comportant des touches à effleurement. Elle s'applique particulièrement bien aux tables de cuisson comportant une plaque supérieure en vitrocéramique munie de touches de commande de la valeur moyenne de la puissance des éléments chauffants, notamment des éléments radiants et/ou des éléments à lampes dites à halogènes.

Une table de cuisson typique comporte quatre éléments chauffants et deux touches marquées + et - par élément chauffant permettant d'augmenter ou de diminuer la puissance délivrée par chaque élément chauffant. La sortie 27 de chaque touche est reliée à un dispositif de commande de la puissance moyenne de l'élément chauffant correspondant.

Il est bien entendu que d'autres applications du clavier selon la présente invention, notamment pour remplacer les claviers de types connus, des potentiomètres ou autres moyens de réglage ou de commande, ne sortent pas du cadre de la présente invention.

La présente invention s'applique notamment à l'industrie électronique.

La présente invention s'applique principalement à la fabrication de tables de cuisson.

## Revendications

1. Clavier étanche comportant au moins une touche formée par un emplacement de réception d'un doigt (17) et en regard de cet emplacement, une antenne (15) alimentée par un générateur haute fréquence fournissant un signal de sortie modifié par le condensateur mis en oeuvre par la pose d'un doigt sur la touche,
**caractérisé en ce que**
- le générateur haute fréquence (1) est un générateur unidirectionnel dont l'entrée est reliée à la masse et la sortie, à une première résistance (19) elle-même reliée à la masse par le montage en parallèle d'une seconde résistance (23) et d'un condensateur (25),
- le condensateur formé par l'antenne (15) et la touche (17) est relié par une borne à la sortie du générateur (1) et par l'autre borne il est mis à la masse (7) par la pose d'un doigt sur la touche (17),
- une sortie de signal (27) reliée à la sortie (21) de la première résistance (19), fournissant un signal de tension de niveau bas en l'absence de doigt posé sur la touche (17) et un signal de tension de niveau haut lorsqu'un doigt est posé sur la touche (17).

2. Clavier selon la revendication 1,
**caractérisé en ce que**
le générateur unidirectionnel haute fréquence (1) comporte, en série, un oscillateur (3), notamment à comparateur, et un redresseur (11), notamment une diode.

3. Clavier selon l'une quelconque des revendications précédentes,
**caractérisé en ce qu'**
il comporte un circuit imprimé et l'antenne (15) formant une touche comporte un élément élastique saillant à partir du circuit imprimé.

4. Clavier selon l'une quelconque des revendications précédentes,
**caractérisé en ce qu'**
il comporte une paroi étanche et rigide (31) dont une première face reçoit l'antenne (15) formant la touche et la seconde face comporte en vis-à-vis de l'antenne (15) un emplacement de réception d'un doigt (17).

5. Clavier selon la revendication 4,
**caractérisé en ce que**
la paroi étanche rigide (31) est réalisée en vitrocéramique.

6. Clavier selon l'une quelconque des revendications précédentes,
**caractérisé en ce qu'**
il commande la puissance d'un appareil électrique et/ou électronique.

7. Appareil électrique et/ou électronique,
**caractérisé en ce qu'**
il comporte au moins un clavier selon l'une quelconque des revendications précédentes.

8. Appareil selon la revendication 7,
**caractérisé en ce qu'**
il est un appareil ménager, notamment un appareil de cuisson.

9. Appareil selon la revendication 8,
**caractérisé en ce que**
l'appareil est une table de cuisson comportant au moins un foyer chauffant pour ustensiles de cuisine et le clavier commande la puissance moyenne délivrée par le ou les foyers.

## Claims

1. Sealed keyboard comprising at least one key formed by a site for receiving a finger (17) and, opposite that site, an aerial (15) supplied by a high-frequency generator providing an output signal modified by the capacitor brought into operation by placing a finger on the key,
**characterised in that**
- the high-frequency generator (1) is a unidirectional generator, the input of which is connected to earth and the output of which is connected to a first resistor (19) which is itself connected to earth by mounting in parallel a second resistor (23) and a capacitor (25),
- the capacitor formed by the aerial (15) and the key (17) is connected by one terminal to the output of the generator (1) and, by the other terminal, it is earthed (7) by placing a finger on the key (17),
- a signal output (27) connected to the output (21) of the first resistor (19), providing a low-level voltage signal in the absence of a finger placed on the key (17) and a high-level voltage signal when a finger is placed on the key (17).

2. Keyboard according to claim 1, **characterised in that** the high-frequency unidirectional generator (1) comprises, in series, an oscillator (3), especially having a comparator, and a rectifier (11), especially a diode.

3. Keyboard according to either of the preceding claims, **characterised in that** it comprises a printed circuit and the aerial (15) forming a key comprises a resilient element projecting from the printed circuit.

4. Keyboard according to any one of the preceding claims, **characterised in that** it comprises a sealed and rigid wall (31), a first face of which receives the aerial (15) forming the key and the second face of which comprises, opposite the aerial (15), a site for receiving a finger (17).

5. Keyboard according to claim 4, **characterised in that** the rigid sealed wall (31) is made of glass-ceramics.

6. Keyboard according to any one of the preceding claims, **characterised in that** it controls the power of an electrical and/or electronic apparatus.

7. Electrical and/or electronic apparatus, **characterised in that** it comprises at least one keyboard according to any one of the preceding claims.

8. Apparatus according to claim 7, **characterised in that** it is a domestic apparatus, especially a cooking apparatus.

9. Apparatus according to claim 8, **characterised in that** the apparatus is a hotplate comprising at least one heat source for cooking utensils and the keyboard controls the average power delivered by the source(s).

## Patentansprüche

1. Abgedichtete Tastatur, mit zumindest einer von einer Aufnahmestelle eines Fingers (17) gebildeten Taste und gegenüber dieser Stelle einer Antenne (15), die von einem Hochfrequenzgenerator gespeist wird, der ein von dem durch das Aufsetzen eines Fingers auf die Taste eingeschalteten Kondensator modifiziertes Ausgangssignal liefert,
**dadurch gekennzeichnet, daß**
- der Hochfrequenzgenerator (1) ein unidirektionaler Generator ist, dessen Eingang mit der Masse und dessen Ausgang mit einem ersten Widerstand (19) verbunden ist, der selbst mit der Masse durch Parallelschaltung eines zweiten Widerstands (23) und eines Kondensators (25) verbunden ist, und
- der von der Antenne (15) und der Taste (17) gebildete Kondensator durch eine Anschlußklemme mit dem Ausgang des Generators (1) verbunden ist und durch eine weitere Anschlußklemme durch das Aufsetzen eines Fingers auf die Taste (17) an die Masse (7) gelegt wird, wobei
- ein mit dem Ausgang (21) des ersten Widerstands (19) verbundener Signalausgang (27) ein Signal geringer Spannungshöhe in Abwesenheit eines auf die Taste (17) aufgesetzten Fingers und ein Signal großer Spannungshöhe liefert, wenn ein Finger auf die Taste (17) aufgesetzt ist.

2. Tastatur nach Anspruch 1, **dadurch gekennzeichnet, daß** der unidirektionale Hochfrequenzgenerator (1), in Reihenschaltung, einen Oszillator (3), insbesondere Komparator-Generator, und einen Gleichrichter (11), insbesondere eine Diode, umfaßt.

3. Tastatur nach einem der vorhergehenden Ansprüche, **dadurch gekennzeichnet, daß** sie eine gedruckte Schaltung aufweist und die eine Taste bildende Antenne (15) ein elastisches Element umfaßt, das von der gedruckten Schaltung vorspringt.

4. Tastatur nach einem der vorhergehenden Ansprüche, **dadurch gekennzeichnet, daß** sie eine abgedichtete und starre Wand (31) aufweist, von der eine erste Fläche die die Taste bildende Antenne (15) aufnimmt, und von der die zweite Fläche gegenüber der Antenne (15) eine Aufnahmestelle eines Fingers (17) bildet.

5. Tastatur nach Anspruch 4, **dadurch gekennzeichnet, daß** die abgedichtete starre Wand (31) von Glaskeramik gebildet ist.

6. Tastatur nach einem der vorhergehenden Ansprüche, **dadurch gekennzeichnet, daß** sie die Leistung eines elektrischen und/oder elektronsichen Gerätes steuert.

7. Elektrisches und/oder elektronisches Gerät, **dadurch gekennzeichnet, daß** es zumindest eine Tastatur nach einem der vorhergehenden Ansprüche umfaßt.

8. Gerät nach Anspruch 7, **dadurch gekennzeichnet, daß** es ein Haushaltsgerät, insbesondere ein Kochgerät, ist.

9. Gerät nach Anspruch 8, **dadurch gekennzeichnet, daß** das Gerät eine Kochplatte mit zumindest einer Heizstelle für Küchenutensilien ist und die Tastatur die von der oder den Heizstellen gelieferte mittlere Leistung steuert.
